# EUROPEAN PATENT APPLICATION

(11) **EP 4 626 185 A1**
(43) Date of publication of application: **01.10.2025**
(21) Application number: 25159019.6
(22) Date of filing: 20.02.2025
(51) Int. Cl.: H10F 71/00, H01L 21/67, H01L 21/677

(54) **TABBING APPARATUS**

(30) Priority: 22.02.2024 KR 20240025913
(71) Applicant: Hanwha Solutions Corporation, Jung-gu Seoul 04541 (KR)
(72) Inventor: JUNG, Min Kyo, 04541 Seoul (KR); BAEK, Dong Heon, 04541 Seoul (KR); CHUNG, Dong Jin, 04541 Seoul (KR)
(74) Representative: Mooser, Sebastian Thomas

(57) **Abstract**

A tabbing apparatus includes a first transfer unit configured to transfer a solar cell string in a first direction, a first heating unit configured to heat the solar cell string transferred by the first transfer unit, a second transfer unit spaced apart from the first transfer unit in the first direction and configured to receive the solar cell string from the first transfer unit, and a second heating unit configured to heat the solar cell string transferred by the second transfer unit.

## Description

### BACKGROUND

### 1. Field of the Invention

The present disclosure relates to a tabbing apparatus, and more specifically, to a tabbing apparatus capable of improving the bonding quality between a solar cell and a wire.

### 2. Discussion of Related Art

In general, solar cells are formed by disposing diodes made of p-n junctions on a substrate. When a solar cell is irradiated with sunlight, electron-hole pairs called excitons are generated, and as the excitons separate, electrons move to an n layer and holes move to a p layer, and accordingly, photovoltaic power is generated at a p-n junction portion.

In general, since a single solar cell generates only a maximum voltage of about 0.5 V, multiple solar cells have to be connected in series to be used. A device obtained by connecting and modularizing multiple unit solar cells is referred to as a solar cell module.

A tabbing process is a process of forming a single solar cell module by disposing a wire on a plurality of solar cells to electrically connect the plurality of solar cells.

The background technology of the present disclosure is disclosed in Korean Patent Publication No. 10-1058399 (registered on August 16, 2011, title of the invention: tabber-stringer and tabbing-stringing method).

### SUMMARY OF THE INVENTION

The present disclosure is directed to providing a tabbing apparatus capable of improving the bonding quality between a solar cell and a wire.

According to an aspect of the present disclosure, there is provided a tabbing apparatus including a first transfer unit configured to transfer a solar cell string in a first direction, a first heating unit configured to heat the solar cell string transferred by the first transfer unit, a second transfer unit spaced apart from the first transfer unit in the first direction and configured to receive the solar cell string from the first transfer unit, and a second heating unit configured to heat the solar cell string transferred by the second transfer unit.

The first transfer unit may include a support member configured to support the solar cell string, a first driving member movably connected to the support member, and a first transfer member connected to the first driving member and configured to transfer the solar cell string in the first direction in conjunction with movement of the first driving member, and the first transfer member may reciprocally move in a direction parallel to the first direction.

The first driving member may include a first driving body installed to be reciprocally movable in a direction parallel to the first direction and a second driving body connected to the first driving body and configured to be reciprocally moved in a direction intersecting the first direction, and the first transfer member may come into contact with or is separated from the solar cell string depending on a movement direction of the second driving body.

The first transfer member may be disposed to face an edge of the solar cell string.

The first direction may be parallel to a length direction of the solar cell string, and the support member and the first transfer member may be arranged in a width direction of the solar cell string.

A width of the support member may be smaller than a width of the solar cell string.

A sum of a width of the support member and a width of the first transfer member may be larger than a width of the solar cell string.

The second transfer unit may include a second transfer member disposed to face the support member and configured to transfer the solar cell string in the first direction, a third transfer member disposed to face the first transfer member at an initial position and installed to be reciprocally movable in a direction intersecting the first direction, and a second driving member configured to adjust a movement direction of the third transfer member in conjunction with movement of the first transfer member.

A distance between the first transfer member and the third transfer member may be smaller than a movement distance of the first transfer member in the first direction.

The second driving member may move the third transfer member from the initial position in a direction intersecting the first direction as the first transfer member is moved in the first direction.

The solar cell string may include a first surface and a second surface which are opposite to each other, the first heating unit may include a first heating member disposed to face the first surface and configured to heat the first surface, and the second heating unit may include a second heating member disposed to face the second surface and configured to heat the second surface.

The second surface may be disposed to face the first transfer unit and the second transfer unit.

The first heating member may be spaced apart from the first transfer unit, and the second heating member may be disposed inside the second transfer unit.

The first heating unit may further include a preheating member spaced apart from the first heating member and configured to heat the second surface.

A heating temperature of the preheating member may be lower than a heating temperature of the second heating member.

The preheating member may include a first preheating member disposed to face the first heating member and a second preheating member spaced apart from the first preheating member in the first direction.

Heating temperatures of the first preheating member and the second preheating member may be different from each other.

### BRIEF DESCRIPTION OF THE DRAWINGS

The above and other objects, features and advantages of the present disclosure will become more apparent to those of ordinary skill in the art by describing exemplary embodiments thereof in detail with reference to the accompanying drawings, in which:
FIG. 1 is a view schematically illustrating a configuration of a tabbing apparatus according to one embodiment of the present disclosure;
FIG. 2 is a side view schematically illustrating a configuration of a first transfer unit according to one embodiment of the present disclosure;
FIG. 3 is a front view schematically illustrating the configuration of the first transfer unit according to one embodiment of the present disclosure;
FIG. 4 is a view schematically illustrating a configuration of a first heating unit according to one embodiment of the present disclosure;
FIG. 5 is a perspective view schematically illustrating a configuration of a second transfer unit according to one embodiment of the present disclosure;
FIG. 6 is a plan view schematically illustrating the configuration of the second transfer unit according to one embodiment of the present disclosure;
FIG. 7 is a side view schematically illustrating the configuration of the second transfer unit according to one embodiment of the present disclosure;
FIGS. 8 to 11 are views schematically illustrating an operation process of the first transfer unit and the first heating unit according to one embodiment of the present disclosure;
FIGS. 12 to 14 are views schematically illustrating an operation process of the second transfer unit and the second heating unit according to one embodiment of the present disclosure;
FIG. 15 is a side view schematically illustrating a configuration of a tabbing apparatus according to another embodiment of the present disclosure; and
FIG. 16 is a view schematically illustrating a configuration of a first heating unit according to another embodiment of the present disclosure.

### DETAILED DESCRIPTION OF EXEMPLARY EMBODIMENTS

Hereinafter, preferred embodiments of the present disclosure will be described in detail with reference to the accompanying drawings. Prior to the description, terms or words used in this specification and claims should not be restrictively interpreted according to ordinary meanings or dictionary-based meanings, but should be interpreted according to meanings and concepts conforming to the technical aspects of the present disclosure on the basis of the principle that an inventor is allowed to properly define concepts of terms to describe his or her invention in the best ways. Therefore, embodiments described in the specification and configurations shown in the drawings are merely some of the most preferred embodiments of the present disclosure, and are not intended to fully describe the technical aspects of the present disclosure, so it should be understood that a variety of other equivalents and modifications could be made thereto at the time of filing the application. In addition, when used herein, the words "comprise" and "include," and/or "comprising" and "including" specify the presence of stated features, numbers, steps, operations, members, elements and/or groups thereof, but do not preclude the presence or addition of one or more other features, numbers, operations, members, elements and/or groups thereof. In addition, when describing embodiments of the present disclosure, the phrase "may perform" or "may be" may include "one or more embodiments of the present disclosure."

Furthermore, to help the understanding of the present disclosure, the accompanying drawings are not drawn to actual scale and the dimensions of some elements may be exaggerated. In addition, the same reference numerals may be assigned to the same components in different embodiments.

The statement that two objects of comparison are "the same" means "substantially the same." Therefore, "substantially the same" may include deviations that are considered to be low in the art, for example, deviations of 5% or less. In addition, uniformity of a parameter over a given region may mean uniformity from an average perspective.

Although "first," "second," etc., are used to describe various components, the components are of course not limited by the terms. The terms are only used to distinguish one component from another, and unless otherwise stated, the first component may of course also be the second component.

Throughout the specification, unless otherwise specifically stated, each element may be singular or plural.

That any component is disposed "at an upper portion (or lower portion)" of a component or "on (or under)" another component may mean not only that the component is disposed in contact with an upper surface (or lower surface) of the other component, but also that another component may be interposed between the other component and the component disposed on (or under) the other component.

Further, when one component is described as being "connected," "coupled," or "linked" to another component, the component may be directly connected or able to be linked to the other component, but it is also to be understood that an additional component may be "interposed" between the two components, or the two components may be "connected," "coupled," or "linked" through an additional component. In addition, when a part is referred to as being "electrically coupled" to another part, this includes not only cases where they are directly coupled, but also cases where they are connected with another element interposed therebetween.

Throughout the specification, "A and/or B," means A, B, or A and B, unless otherwise specified. That is, "and/or" includes any or all combinations of the listed items. "C to D" means C or more and D or less, unless otherwise specifically stated.

When a phrase such as "at least one of A, B, and C," "at least one of A, B, or C," "at least one selected from the group A, B, and C," or "at least one selected from A, B, and C" is used to specify a list of elements A, B, and C, the phrase may refer to any suitable combination.

The term "use" may be considered synonymous with the term "utilize." As used in the present specification, the terms "substantially," "about," and similar terms are used as terms of approximation rather than as terms of degree, and are intended to take into account the inherent variation in measured or calculated values that will be recognized by those of ordinary skill in the art.

Although the terms "first," "second," "third," etc. may be used in the present specification to describe various elements, components, regions, layers and/or sections, the elements, components, regions, layers and/or sections should not be limited by the terms. The terms are used to distinguish one element, component, region, layer, or section from another element, component, region, layer, or section. Accordingly, a first element, component, region, layer or section discussed below may be termed a second element, component, region, layer or section without departing from the teachings of exemplary embodiments.

For ease of description, spatially relative terms such as "beneath," "below," "lower," "above," "upper," and the like may be used in the present specification to describe the relationship of one element or feature to another element(s) or feature(s) as illustrated in the drawings. Spatially relative positions will be understood to encompass different orientations of a device in use or operation in addition to the orientation depicted in the figures. For example, when a device in a drawing is overturned, an element described as "below" or "beneath" another element is understood to be "on" or "above" the other element. Therefore, the term "below" may encompass both upward and downward directions.

Terms used in the present specification are for the purpose of describing embodiments of the present disclosure and are not intended to limit the present disclosure.

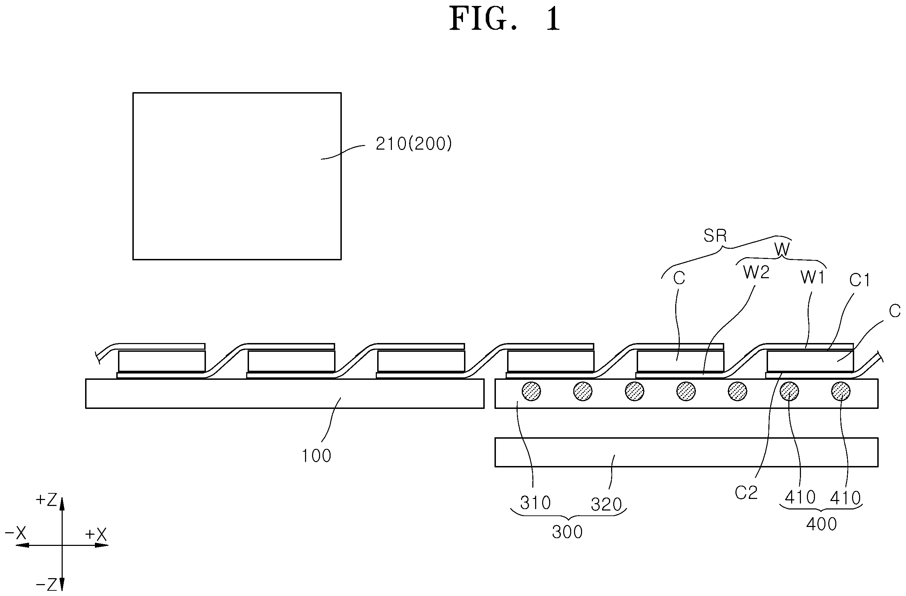

FIG. 1 is a view schematically illustrating a configuration of a tabbing apparatus according to one embodiment of the present disclosure.

Referring to FIG. 1, the tabbing apparatus according to the present embodiment is a device for forming a solar cell string SR by connecting a solar cell C and a wire W, and may include a first transfer unit 100, a first heating unit 200, a second transfer unit 300, and a second heating unit 400.

The first transfer unit 100 may transfer the solar cell string SR in a first direction. That is, the first transfer unit 100 may function as a configuration that continuously transfers the solar cell string SR in the first direction. Here, the first direction may be a +X-axis direction based on FIG. 1.

The solar cell string SR may include the solar cell C and the wire W.

The solar cell C has a semiconductor junction region having a p-n junction surface, and when the solar cell C is irradiated with energy of a certain magnitude or greater, an electromotive force is generated so that light energy is converted into electrical energy. The material of the semiconductor included in the solar cell C is not particularly limited, and silicon (single crystal, polycrystalline, and amorphous), gallium arsenide, cadmium tellurium, cadmium sulfide, indium phosphide, copper indium gallium selenide (CIGS), an organic dye, or a mixture thereof may be used.

The solar cell C may include a first surface C1 and a second surface C2 which are opposite to each other and parallel to the first direction. The first surface C1 and the second surface C2 may function as positive and negative electrodes of the solar cell C, respectively. The first surface C1 and the second surface C2 may be spaced apart in a second direction. Here, the second direction is a direction intersecting the first direction, and may be a +Z-axis direction based on FIG. 1.

The first surface C1 and the second surface C2 of the solar cell string SR to be described below may be the same surfaces as the first surface C1 and the second surface C2 of the solar cell C, respectively.

A plurality of solar cells C may be provided. The plurality of solar cells C may be arranged in the first direction.

The wire W may function as a conductor for electrically connecting the plurality of solar cells C to each other. The wire W may electrically connect a pair of solar cells C disposed adjacent to each other in the solar cell module.

The wire W may have a length direction extending in the first direction. Both sides of the wire W may be disposed to face a pair of adjacent solar cells C in the first direction. As one example, the wire W may include a first portion W1 facing a first surface C1 of one of the adjacent solar cells C, and a second portion W2 facing a second surface C2 of the other.

A plurality of wires W may be provided. The plurality of wires W may be individually disposed between adjacent solar cells C.

In any one solar cell C, a plurality of wires W may be disposed in parallel in a third direction. Here, the third direction is a direction intersecting the first direction and the second direction, and may be a +Y-axis direction based on FIG. 1.

The wire W may be electrically connected to the solar cell C through an electrically conductive adhesive (ECA) curing process. In this case, the solar cell C and the wire W may be transferred in the first direction by a transfer line 10 in a state in which ECA is applied to the surface. Alternatively, the wire W may be electrically connected to the solar cell C through a soldering process. In this case, the solar cell C and the wire W may be transferred in the first direction by the transfer line 10 in a state in which flux is applied to the surface.

A length direction of the solar cell string SR described below may be a direction parallel to the first direction, and a width direction of the solar cell string SR may be a direction parallel to the third direction.

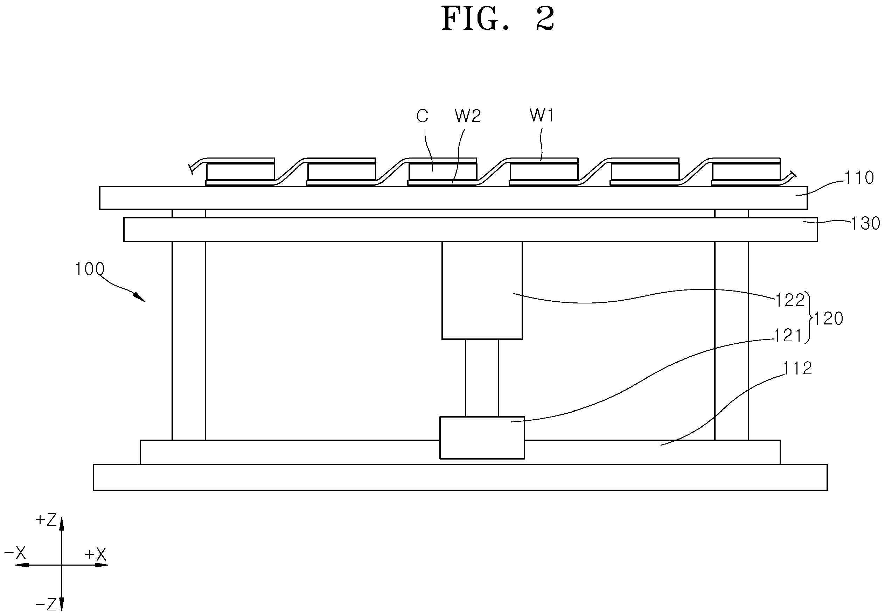

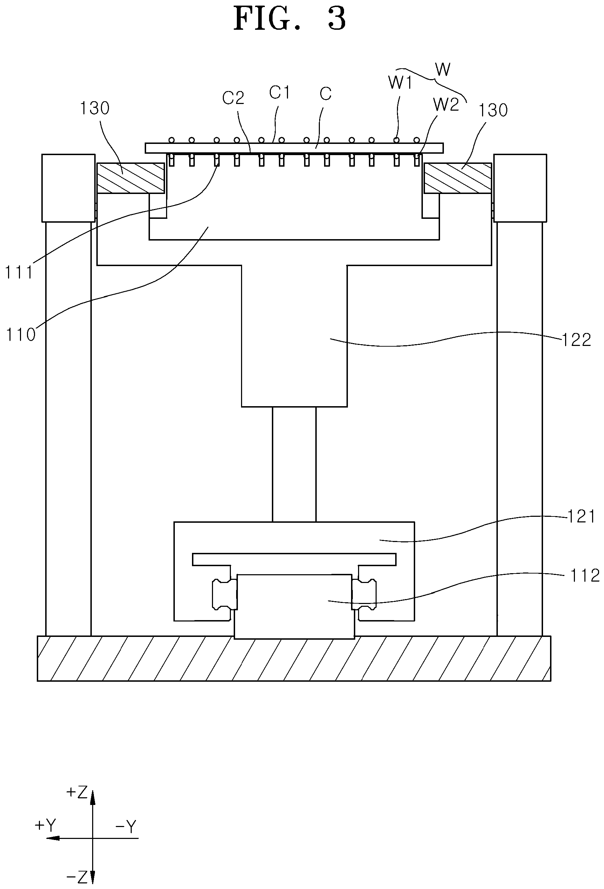

FIG. 2 is a side view schematically illustrating a configuration of the first transfer unit according to one embodiment of the present disclosure, and FIG. 3 is a front view schematically illustrating the configuration of the first transfer unit according to one embodiment of the present disclosure.

Referring to FIGS. 2 and 3, the first transfer unit 100 according to the present embodiment may include a support member 110, a first driving member 120, and a first transfer member 130.

The support member 110 may form a skeleton of the first transfer unit 100 and function as a structure that supports the first driving member 120 and the first transfer member 130 to be described below as a whole.

The support member 110 may support the solar cell string SR. For example, the second surface C2 of the solar cell string SR may be seated on one surface of the support member 110. Accordingly, the support member 110 may prevent the solar cell string SR from falling due to gravity or the like. The shape of the support member 110 is not limited to the shape illustrated in FIGS. 2 and 3, and the design thereof may be changed in various ways within the technical concept that it is capable of supporting the first driving member 120 and the solar cell string SR.

A groove 111 into which the second portion W2 of the wire W is inserted may be formed in the support member 110. The groove 111 according to the present embodiment may have the shape of a groove that is concavely formed toward the interior of the support member 110 from one surface of the support member 110 facing the second surface C2 of the solar cell string SR. The groove 111 may have a length direction extending to be parallel to the first direction. As the solar cell string SR is seated on the support member 110, the second portion W2 of the wire W may be inserted into the interior of the groove 111. Accordingly, the groove 111 may prevent the second portion W2 of the wire W from being deformed or damaged during the process of transferring the solar cell string SR.

A rail portion 112 may be formed on the support member 110 to guide the movement of the first driving member 120 to be described below. The rail portion 112 according to the present embodiment may be disposed at a position spaced apart from the second surface C2 of the solar cell string SR in an opposite direction to the second direction. The rail portion 112 may have a length direction extending parallel to the first direction.

The first driving member 120 may be movably connected to the support member 110, and may change the position of the first transfer member 130 to be described below.

The first driving member 120 according to the present embodiment may include a first driving body 121 and a second driving body 122.

The first driving body 121 may be installed to be reciprocally movable in a direction parallel to the first direction. The first driving body 121 according to the present embodiment may be disposed at a position spaced apart from the second surface C2 of the solar cell string SR in the opposite direction to the second direction. The first driving body 121 may be connected to the rail portion 112 to be reciprocally movable in a direction parallel to the first direction. The first driving body 121 may receive driving power from a power device (not illustrated) such as a motor, a cylinder, or the like to reciprocally move in the direction parallel to the first direction.

The second driving body 122 may reciprocally move in a direction intersecting the first direction. The second driving body 122 according to the present embodiment may be disposed at a position spaced apart from the second surface C2 of the solar cell string SR in the opposite direction to the second direction. The second driving body 122 may be connected to the first driving body 121 to be reciprocally movable in a direction parallel to the second direction. The second driving body 122 may receive driving power from a power device (not illustrated) such as a motor, a cylinder, or the like to reciprocally move in the direction parallel to the second direction.

The first transfer member 130 may be connected to the first driving member 120, and may transfer the solar cell string SR in the first direction in conjunction with the movement of the first driving member 120.

The first transfer member 130 according to the present embodiment may be connected to the second driving body 122. The first transfer member 130 may be disposed to face the second surface C2 of the solar cell string SR in the second direction. The first transfer member 130 may be disposed so that a length direction thereof is parallel to the first direction.

The first transfer member 130 may be reciprocally moved in the direction parallel to the first direction together with the first driving body 121 when the first driving body 121 operates. In addition, the first transfer member 130 may be reciprocally moved in the direction parallel to the second direction when the second driving body 122 operates.

The first transfer member 130 may be moved in a circular manner along a set path. For example, the first transfer member 130 may be sequentially moved in the second direction, the first direction, the opposite direction of the second direction, and the opposite direction of the first direction.

The first transfer member 130 may come into contact with the second surface C2 of the solar cell string SR as the second driving body 122 is moved in the second direction.

Then, as the first driving body 121 is moved in the first direction, the first transfer member 130 is moved in the first direction while in contact with the second surface C2 of the solar cell string SR, thereby moving the solar cell string SR in the first direction. When the first transfer member 130 is moved in the first direction, an end of the first transfer member 130 may protrude a set distance outward from the support member 110 in the direction parallel to the first direction.

Then, the first transfer member 130 may be separated from the second surface C2 of the solar cell string SR as the second driving body 122 is moved in the opposite direction to the second direction. When the first transfer member 130 is moved in the opposite direction to the second direction, the solar cell string SR may be seated on the support member 110 or the second transfer unit 300 to be described below to remain separated from the transfer member 130.

Then, the first transfer member 130 may be moved in the opposite direction to the first direction as the first driving body 121 is moved in the opposite direction to the first direction, and may be returned to its initial position. Accordingly, the solar cell string SR may be moved stepwise at set time intervals by a movement distance of the first transfer member 130 in the first direction.

The first transfer member 130 may be disposed to face the support member 110 in a width direction of the solar cell string SR, more specifically, in the third direction. That is, the support member 110 and the first transfer member 130 may be arranged in the third direction.

A width of the support member 110 parallel to the third direction may be smaller than a width of the solar cell string SR parallel to the third direction. Accordingly, a portion of the second surface C2 of the solar cell string SR may be disposed so as not to face the support member 110, and the first transfer member 130 may be disposed to face the portion of the second surface C2 of the solar cell string SR that does not face the support member 110. As one example, the support member 110 may be disposed to face the center of the solar cell string SR, and the first transfer member 130 may be disposed to face an edge of the solar cell string SR.

The sum of the width of the support member 110 parallel to the third direction and the width of the first transfer member 130 parallel to the third direction may be greater than the width of the solar cell string SR parallel to the third direction. Accordingly, the first transfer member 130 may stably transfer the solar cell string SR by securing a relatively large contact area with the second surface C2 of the solar cell string SR.

A pair of first transfer members 130 may be provided. The pair of first transfer members 130 may be symmetrically disposed on both sides of the support member 110 with the support member 110 interposed therebetween. However, the number and arrangement form of the first transfer member 130 are not limited thereto and the design thereof may be changed in various ways.

The first heating unit 200 may heat the solar cell string SR transferred by the first transfer unit 100. That is, the first heating unit 200 may function as a component that primarily heats the solar cell string SR to cure the ECA applied between the solar cell C and the wire W or to melt a solder layer of the wire W to bond the solar cell C and the wire W to each other.

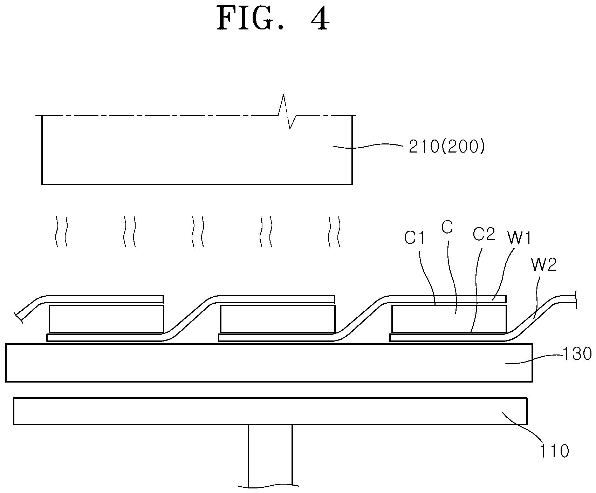

FIG. 4 is a view schematically illustrating a configuration of the first heating unit according to one embodiment of the present disclosure.

Referring to FIG. 4, the first heating unit 200 may include a first heating member 210.

The first heating member 210 may be disposed to face the first surface C1 of the solar cell string SR. That is, the first heating member 210 may function as a component that applies heat to the first surface C1 of the solar cell string SR to bond the first portion W1 of the wire W to the solar cell C.

The first heating member 210 according to the present embodiment may be disposed at a position spaced apart from the first transfer unit 100 and the first surface C1 of the solar cell string SR in the second direction. The first heating member 210 may include an infrared lamp that generates heat by radiating infrared rays toward the first surface C1 of the solar cell string SR. However, the first heating member 210 is not limited to these matters, and may be configured to include various types of heat sources such as a hot air device, a cartridge heater, or the like. A heating temperature of the first heating member 210 may be 150°C or lower. When the heating temperature of the first heating member 210 exceeds 150°C, damage to the solar cell string SR may occur.

The first heating member 210 may be installed to be reciprocally movable in the direction parallel to the second direction. Accordingly, the first heating member 210 may be moved in the second direction or in the opposite direction to the second direction to adjust the amount of heat transferred to the first surface C1 of the solar cell string SR and avoid interfering with the transfer of the solar cell string SR.

The first heating member 210 may be operated alternately with the first transfer unit 100. For example, the first heating member 210 may heat the solar cell string SR when the first transfer member 130 is separated from the solar cell string SR and the transfer of the solar cell string SR is stopped. In addition, the first heating member 210 may stop the heating operation for the solar cell string SR when the first transfer member 130 comes into contact with the solar cell string SR and the transfer of the solar cell string SR is performed. However, the first heating member 210 is not limited to this operation, and may be configured to perform an operation independent of the first transfer unit 100.

The second transfer unit 300 may be disposed to be spaced apart from the first transfer unit 100 in the first direction. The second transfer unit 300 may receive the solar cell string SR from the first transfer unit 100 and transfer the received solar cell string SR in the first direction.

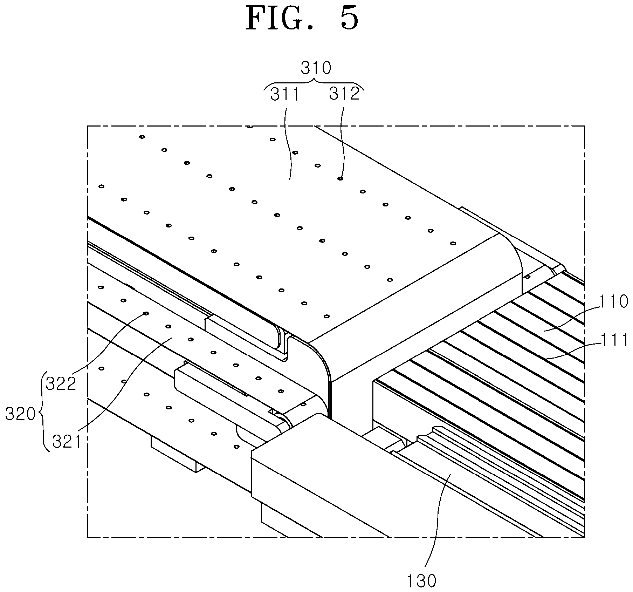

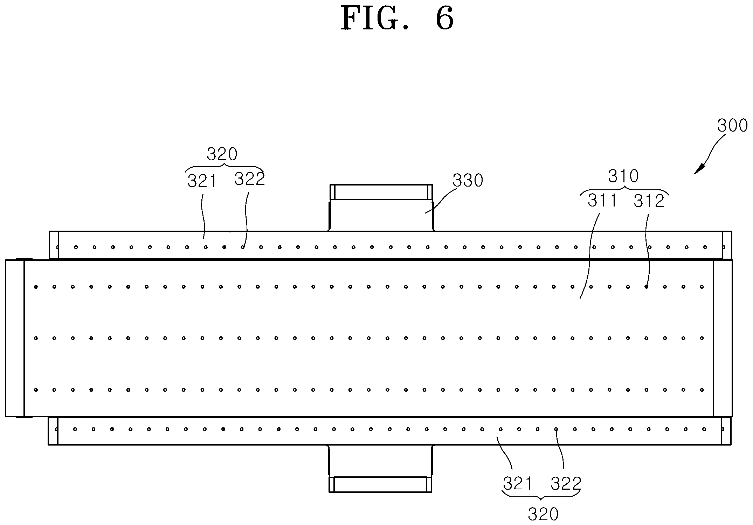

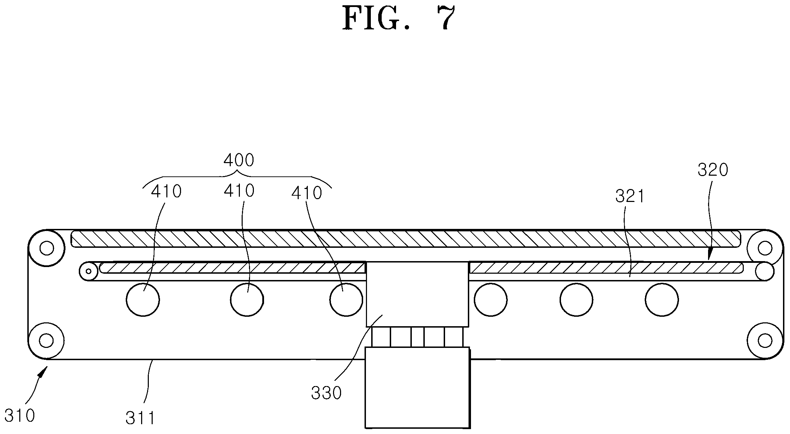

FIG. 5 is a perspective view schematically illustrating a configuration of the second transfer unit according to one embodiment of the present disclosure, FIG. 6 is a plan view schematically illustrating the configuration of the second transfer unit according to one embodiment of the present disclosure, and FIG. 7 is a side view schematically illustrating the configuration of the second transfer unit according to one embodiment of the present disclosure.

Referring to FIGS. 1 to 7, the second transfer unit 300 according to the present embodiment may include a second transfer member 310, a third transfer member 320, and a second driving member 330.

The second transfer member 310 may form the exterior of one side of the second transfer unit 300 and transfer the solar cell string SR in the first direction. The second transfer member 310 may be disposed so that a length direction thereof is parallel to the first direction. The second transfer member 310 may be disposed at a position spaced a predetermined distance from the support member 110 in the first direction.

A width of the second transfer member 310 in the width direction of the solar cell string SR, that is, parallel to the third direction, may be smaller than the width of the solar cell string SR parallel to the third direction. In this case, the width of the second transfer member 310 parallel to the third direction may be equal to or smaller than the width of the support member 110 parallel to the third direction.

The second transfer member 310 according to the present embodiment may include a first belt member 311.

The first belt member 311 may be installed to be rotatable around the width direction of the solar cell string SR, that is, the third direction. The first belt member 311 may transfer the solar cell string SR in the first direction while circulating in an endless track manner. The first belt member 311 may be formed of a material having high heat resistance, for example, a material containing Teflon (polytetrafluoroethylene (PTFE)).

The second transfer member 310 may further include a first suction hole 312.

The first suction hole 312 is formed to pass through the first belt member 311, and may generate vacuum pressure to suck and fix the solar cell string SR to the first belt member 311. The first suction hole 312 may be connected to a vacuum pressure generating device (not illustrated), such as a vacuum pump, compressor, or the like, installed inside or outside the first belt member 311.

A plurality of first suction holes 312 may be provided. The first suction holes 312 may be disposed in at least two rows in directions parallel to the first direction and the third direction on the first belt member 311.

The third transfer member 320 may form the exterior of the other side of the second transfer unit 300 and transfer the solar cell string SR in the first direction. The third transfer member 320 may be disposed so that a length direction thereof is parallel to the first direction. The second transfer member 310 may be disposed at a position spaced a predetermined distance from the first transfer member 130 in the first direction.

Since the width of the second transfer member 310 parallel to the third direction is formed to be smaller than the width of the solar cell string SR parallel to the third direction, the third transfer member 320 may be disposed to face a portion of the second surface C2 of the solar cell string SR that does not face the second transfer member 310. For example, the second transfer member 310 may be disposed to face the center of the solar cell string SR, and the second transfer member 310 may be disposed to face the edge of the solar cell string SR.

A pair of third transfer members 320 may be provided. The pair of third transfer members 320 may be symmetrically disposed on both sides of the second transfer member 310.

The third transfer member 320 may be installed to be reciprocally moved in the direction intersecting the first direction. For example, the third transfer member 320 may be installed to be reciprocally moved in the direction parallel to the second direction. However, the third transfer member 320 is not limited thereto, and may also be installed to be reciprocally moved in the direction parallel to the third direction.

The third transfer member 320 may be disposed to face the first transfer member 130 at its initial position. That is, when the third transfer member 320 is located at the initial position, all or a part of an end surface of the first transfer member 130 and an end surface of the third transfer member 320 may be disposed to face each other in the first direction. When the third transfer member 320 is moved from the initial position in the direction intersecting the first direction, the third transfer member 320 may be disposed to be misaligned with the first transfer member 130. That is, when the third transfer member 320 is moved more than a set distance in the direction intersecting the first direction from the initial position, the end surface of the first transfer member 130 and the end surface of the third transfer member 320 may not be disposed to face each other in the first direction.

When the third transfer member 320 is located at the initial position, the distance between the first transfer member 130 and the third transfer member 320 may be smaller than the movement distance of the first transfer member 130 in the first direction. Accordingly, when the first transfer member 130 is moved in the first direction, the first transfer member 130 may collide with the third transfer member 320 located at the initial position. Accordingly, the third transfer member 320 is moved in the direction intersecting the first direction during the operation process of the first transfer member 130 by the second driving member 330 to be described below, and interference with the first transfer member 130 may be avoided.

The third transfer member 320 according to the present embodiment may include a second belt member 321.

The second belt member 321 may be installed to be rotatable around the width direction of the solar cell string SR, that is, the third direction. The second belt member 321 may transfer the solar cell string SR in the first direction while circulating in an endless track manner. The second belt member 321 may be formed of a material having high heat resistance, such as a material containing Teflon (PTFE).

The third transfer member 320 may further include a second suction hole 322.

The second suction hole 322 may be formed to pass through the second belt member 321, and may generate vacuum pressure to suck and fix the solar cell string SR to the second belt member 321. The second suction hole 322 may be connected to a vacuum pressure generating device (not illustrated), such as a vacuum pump, compressor, or the like, installed inside or outside the second belt member 321.

A plurality of second suction holes 322 may be provided. The second suction holes 322 may be disposed in at least two rows in directions parallel to the first direction and the third direction on the second belt member 321.

The second driving member 330 may be connected to the third transfer member 320, and may generate a driving force to move the third transfer member 320 in the direction intersecting the first direction. The second driving member 330 may adjust the movement direction of the third transfer member 320 in conjunction with the movement of the first transfer member 130.

One side of the second driving member 330 according to the present embodiment may be connected to the second transfer member 310 and the other side thereof may be connected to the third transfer member 320.

The second driving member 330 may include various types of transfer devices capable of moving the third transfer member 320 in the direction intersecting the first direction, for example, in a direction parallel to the second direction, by its own driving force, such as a hydraulic cylinder, a ball screw, and the like, and a control device capable of controlling the operation of the transfer device based on movement data of the first transfer member 130. The control device may be implemented as a central processing unit (CPU) or a system on chip (SoC), and may control a plurality of hardware or software components connected to a processor by executing an operating system or application, and perform various data processing and calculations. The control device may be configured to execute at least one command stored in a memory and store execution result data in the memory.

As the first transfer member 130 is moved in the first direction, the second driving member 330 may move the third transfer member 320 from the initial position in the direction intersecting the first direction, for example, in the opposite direction to the second direction.

Then, as the first transfer member 130 is moved in the opposite direction to the first direction, the second driving member 330 may move the third transfer member 320 in the second direction so that the third transfer member 320 is returned to the initial position.

The second heating unit 400 may heat the solar cell string SR transferred by the second transfer unit 300. That is, the second heating unit 400 may function as a component that secondarily heats the solar cell string SR that has been primarily heated by the first heating unit 200 to cure the ECA applied between the solar cell C and the wire W or to melt a solder layer of the wire W to bond the solar cell C and the wire W to each other.

The second heating unit 400 may include a second heating member 410.

The second heating member 410 may be disposed to face the second surface C2 of the solar cell string SR. That is, the second heating member 410 may function as a component that applies heat to the second surface C2 of the solar cell string SR to bond the second portion W2 of the wire W to the solar cell C.

The second heating member 410 according to the present embodiment may be disposed inside the second transfer unit 300. As one example, as illustrated in FIG. 7, the second heating member 410 may be disposed inside the second transfer member 310. However, the second heating member 410 is not limited thereto, and may be disposed inside the third transfer member 320, or may be disposed inside both the second transfer member 310 and the third transfer member 320.

The second heating member 410 may include a cartridge heater that converts externally applied electrical energy into thermal energy to heat the second surface C2 of the solar cell string SR. However, the second heating member 410 is not limited to these matters, and may be configured to include various types of heat sources such as a hot air device, an infrared lamp, or the like.

The heating temperature of the second heating member 410 may be different from the heating temperature of the first heating member 210, and conversely, the heating temperature of the second heating member 410 may be the same as the heating temperature of the first heating member 210. The heating temperature of the second heating member 410 may be 150°C or lower.

A plurality of second heating members 410 may be provided. The plurality of second heating members 410 may be arranged in the first direction. Accordingly, the plurality of second heating members 410 may uniformly heat the solar cell string SR over the entire length of the second transfer unit 300.

Hereinafter, the operation of the tabbing apparatus according to one embodiment of the present disclosure will be described.

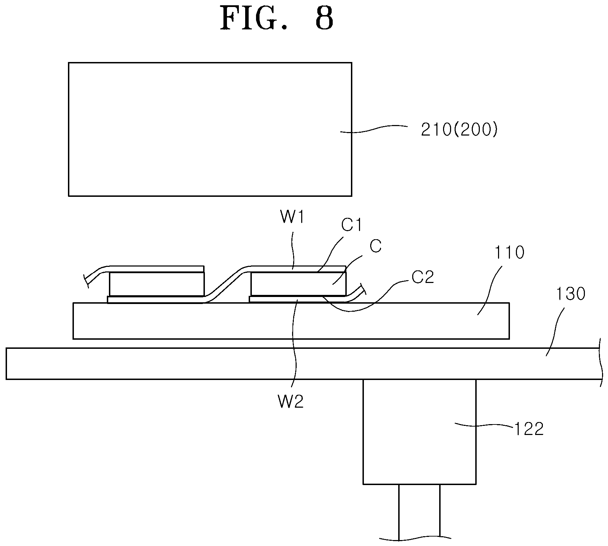

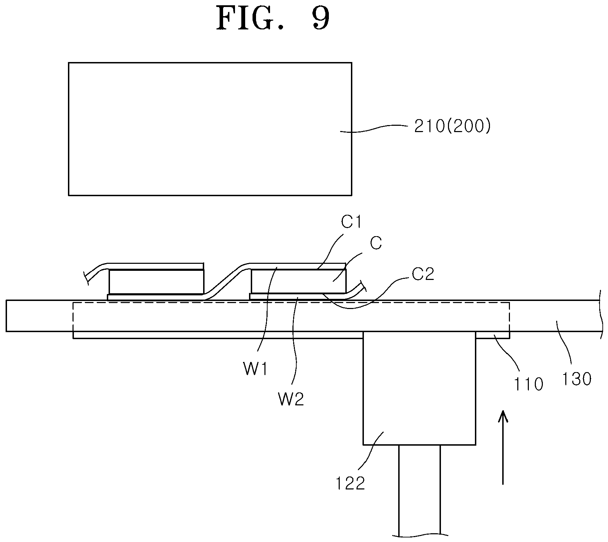

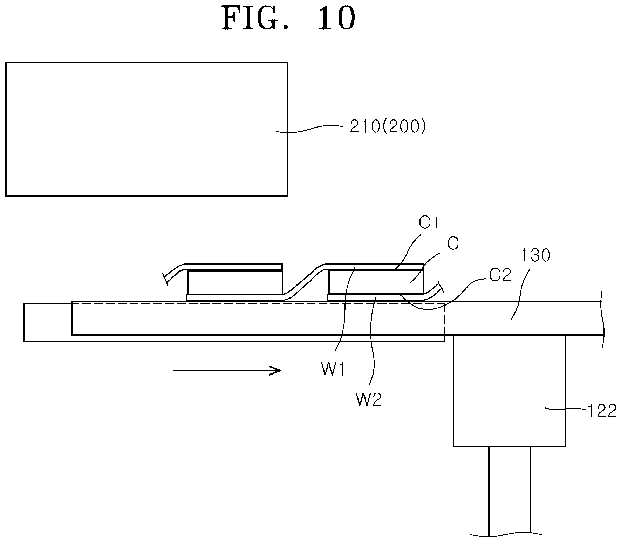

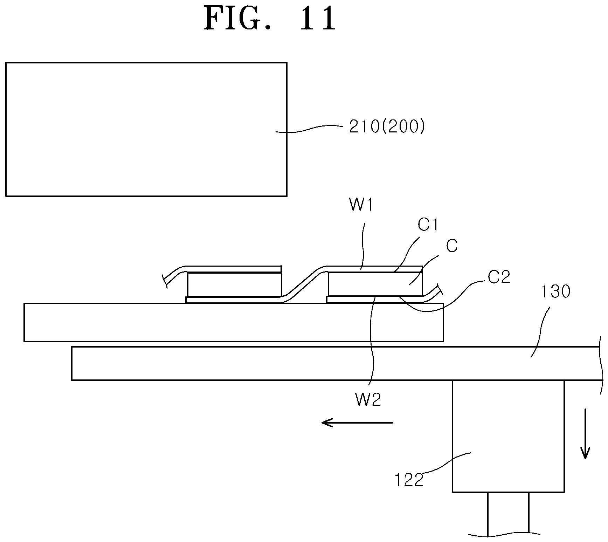

FIGS. 8 to 11 are views schematically illustrating an operation process of the first transfer unit and the first heating unit according to one embodiment of the present disclosure.

Referring to FIG. 8, in a state where the solar cell string SR is seated on the support member 110, as the second driving body 122 is moved in the second direction, the first transfer member 130 comes into contact with the second surface C2 of the solar cell string SR.

As the first driving body 121 is moved in the first direction, the first transfer member 130 is moved in the first direction while in contact with the second surface C2 of the solar cell string SR.

The solar cell string SR is moved in the first direction by the distance that the first transfer member 130 is moved in the first direction.

Then, the second driving body 122 is moved in the opposite direction to the second direction, and the first transfer member 130 is separated from the second surface C2 of the solar cell string SR.

When the first transfer member 130 is moved in the opposite direction to the second direction, the solar cell string SR may be seated on the support member 110 and maintained separated from the transfer member 130.

Then, the first driving body 121 is moved in the opposite direction to the first direction, and the first transfer member 130 is moved in the opposite direction to the first direction while separated from the solar cell string SR and returned to the initial position.

The first heating member 210 heats the first surface C1 of the solar cell string SR in the process in which the solar cell string SR is transferred by the first transfer unit 100.

In this case, the first heating member 210 may heat the solar cell string SR when the first transfer member 130 is separated from the solar cell string SR and the transfer of the solar cell string SR is stopped.

Unlike this, the first heating member 210 may continuously heat the solar cell string SR in the process of transferring the solar cell string SR.

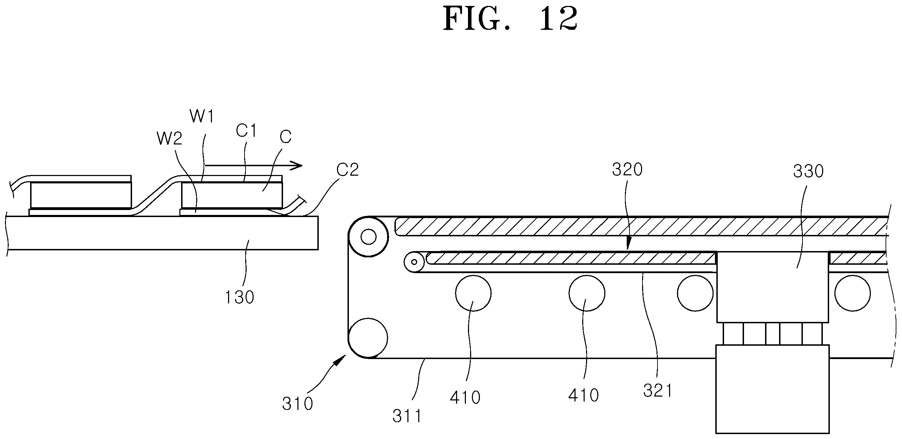

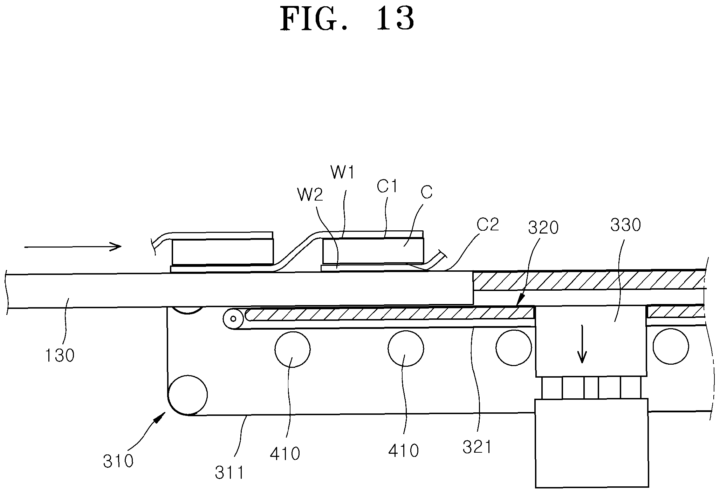

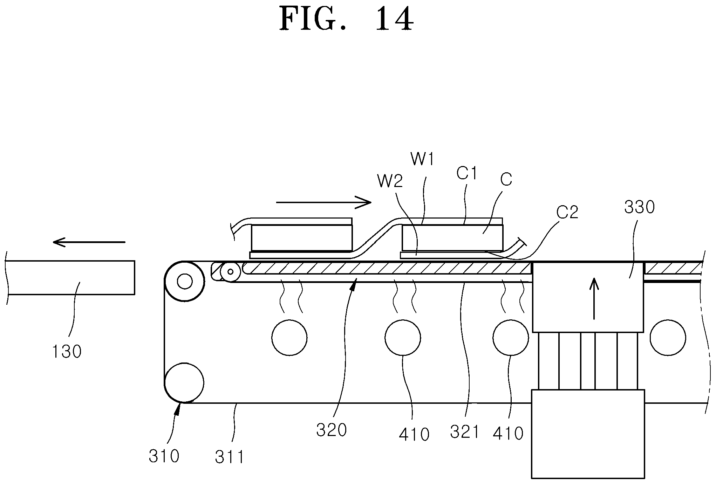

FIGS. 12 to 14 are views schematically illustrating an operation process of the second transfer unit and the second heating unit according to one embodiment of the present disclosure.

When the first transfer member 130 is moved in the first direction, the end of the first transfer member 130 protrudes outward from the support member 110 in the first direction and is moved toward the third transfer member 320.

As the first transfer member 130 is moved in the first direction, the second driving member 330 moves the third transfer member 320 from the initial position in the opposite direction to the second direction.

Accordingly, the end of the first transfer member 130 may be disposed to face a side surface of the second transfer member 310 without colliding with the third transfer member 320.

The solar cell string SR transferred in the first direction by the first transfer member 130 may be fixed to the first belt member 311 by a suction force of the first suction hole 312, or may be seated on the first belt member 311 by the movement of the first transfer member 130 in the opposite direction to the second direction.

The second transfer member 310 transfers the solar cell string R received from the first transfer member 130 in the first direction by the rotational operation of the first belt member 311.

Then, when the first transfer member 130 is moved in the opposite direction to the first direction, the second driving member 330 moves the third transfer member 320 in the second direction, and the third transfer member 320 is returned to the initial position.

The third transfer member 320 transfers the solar cell string R in the first direction together with the second transfer member 310 while supporting an edge side of the solar cell string SR. The edge side of the solar cell string SR may be fixed to the second belt member 321 by a suction force of the second suction hole 322 of the third transfer member 320, or may be seated on the second belt member 321.

In the process in which the solar cell string SR is transferred in the first direction by the second transfer member 310 and the third transfer member 320, the second heating member 410 heats the second surface C2 of the solar cell string SR.

Hereinafter, a tabbing apparatus according to another embodiment of the present disclosure will be described.

The tabbing apparatus according to the present embodiment may be configured to differ only in the detailed configuration of the first heating unit 200 from the tabbing apparatus according to one embodiment of the present disclosure.

Accordingly, in describing the tabbing apparatus according to the present embodiment, only the detailed configuration of the first heating unit 200 that is different from the tabbing apparatus according to one embodiment of the present disclosure will be described. The description of the tabbing apparatus according to one embodiment of the present disclosure may be applied as it is to remaining components of the tabbing apparatus according to the present embodiment.

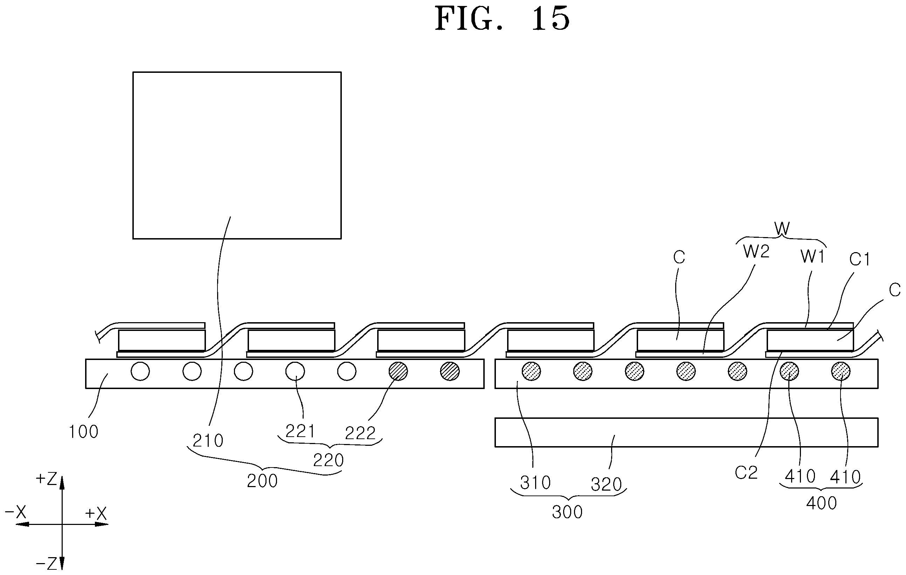

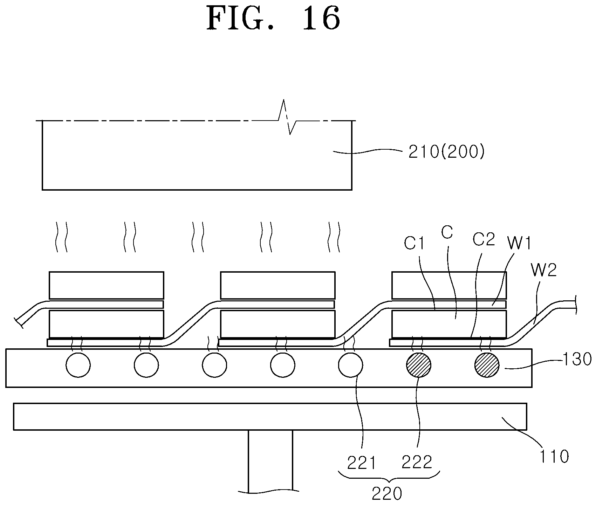

FIG. 15 is a side view schematically illustrating a configuration of the tabbing apparatus according to another embodiment of the present disclosure, and FIG. 16 is a view schematically illustrating a configuration of a first heating unit according to another embodiment of the present disclosure.

Referring to FIGS. 15 and 16, a first heating unit 200 according to the present embodiment may further include a preheating member 220.

The preheating member 220 may be spaced apart from the first heating member 210, and may heat a second surface C2 of a solar cell string SR. That is, the preheating member 220 may function as a component that primarily adds heat to the second surface C2 of the solar cell string SR transferred by a first transfer unit 100 before a second heating member 410. Accordingly, the preheating member 220 may reduce a difference in heat transfer efficiency between a first surface C1 and the second surface C2 that occurs when the second surface C2 of the solar cell string SR is supported by the first transfer unit 100 and a second transfer unit 300.

The preheating member 220 may be disposed inside the first transfer unit 100. As one example, the preheating member 220 may be disposed inside the support member 110 or at a position spaced apart from the support member 110 in the opposite direction to the second direction.

The heating temperature of the preheating member 220 may be lower than the heating temperature of the second heating member 410. The design of the heating temperature of the preheating member 220 and the second heating member 410 may be changed in various ways within a range of 150°C or less.

The preheating member 220 may include a first preheating member 221 and a second preheating member 222.

The first preheating member 221 may be disposed to face the first heating member 210.

The first preheating member 221 according to the present embodiment may include a cartridge heater that converts externally applied electrical energy into thermal energy to heat the second surface C2 of the solar cell string SR. However, the first preheating member 221 is not limited to these matters, and may be configured to include various types of heat sources such as a hot air device, an infrared lamp, or the like.

The first preheating member 221 may be disposed to face the first heating member 210 in the second direction inside the support member 110. The first preheating member 221 may simultaneously heat the first surface C1 and the second surface C2 of the solar cell string SR together with the first heating member 210 when the first heating member 210 operates.

A plurality of first preheating members 221 may be provided. The plurality of first preheating members 221 may be arranged in the first direction. The number, spacing, and the like of the first preheating members 221 may be designed in various ways depending on the size or the like of the first heating member 210.

The second preheating member 222 may be spaced apart from the first preheating member 221 in the first direction. The second preheating member 222 may be disposed at a position that does not directly face the first heating member 210. The second preheating member 222 may function as a component that heats the second surface C2 of the solar cell string SR between the first preheating member 221 and the second heating member 410. Accordingly, the second preheating member 222 may prevent the temperature of the solar cell string SR passing through the first preheating member 221 from excessively dropping before it is transferred to the second heating member 410.

The second preheating member 222 according to the present embodiment may include a cartridge heater that converts externally applied electrical energy into thermal energy to heat the second surface C2 of the solar cell string SR. However, the second preheating member 222 is not limited to these matters, and may be configured to include various types of heat sources such as a hot air device, an infrared lamp, or the like.

A plurality of second preheating members 222 may be provided. The plurality of second preheating members 222 may be arranged in the first direction. The number, spacing, and the like of the second preheating members 222 may be designed in various ways depending on the length or the like of the first transfer unit 100.

The heating temperatures of the first preheating member 221 and the second preheating member 222 may be different from each other. For example, the heating temperature of the second preheating member 222 may have a value between the heating temperature of the first preheating member 221 and the heating temperature of the second heating member 410. However, the heating temperature of the second preheating member 222 is not limited thereto and may be lower than the heating temperature of the first preheating member 221.

According to the present disclosure, a transfer operation of a solar cell string from a first transfer unit to a second transfer unit can be smoothly performed by a reciprocating movement of a third transfer member.

According to the present disclosure, the bonding quality between a solar cell and a wire can be improved by heating a solar cell string in multiple stages by a first heating unit and a second heating unit.

According to the present disclosure, a first heating member and a second heating member can heat different surfaces of a solar cell string, thereby ensuring uniform bonding quality on both surfaces of the solar cell string.

According to the present disclosure, since a preheating member primarily heats a second surface of a solar cell string prior to a second heating member, the bonding quality on a second surface of the solar cell string that is disposed to face first and second transfer units to have relatively low heat transfer efficiency can be further improved.

Although the present disclosure has been described with reference to the embodiments illustrated in the drawings, it is merely exemplary, and it is to be understood to those skilled in the art that various modifications and equivalent other embodiments could be made therefrom.

Therefore, the technical protection scope of the present disclosure should be defined only by the claims.

## Claims

1. A tabbing apparatus comprising:
a first transfer unit configured to transfer a solar cell string in a first direction;
a first heating unit configured to heat the solar cell string transferred by the first transfer unit;
a second transfer unit spaced apart from the first transfer unit in the first direction and configured to receive the solar cell string from the first transfer unit; and
a second heating unit configured to heat the solar cell string transferred by the second transfer unit.

2. The tabbing apparatus of claim 1, wherein the first transfer unit includes:
a support member configured to support the solar cell string;
a first driving member movably connected to the support member; and
a first transfer member connected to the first driving member and configured to transfer the solar cell string in the first direction in conjunction with movement of the first driving member, and
the first transfer member reciprocally moves in a direction parallel to the first direction.

3. The tabbing apparatus of claim 2, wherein the first driving member includes:
a first driving body installed to be reciprocally movable in a direction parallel to the first direction; and
a second driving body connected to the first driving body and configured to be reciprocally moved in a direction intersecting the first direction, and
the first transfer member comes into contact with or is separated from the solar cell string depending on a movement direction of the second driving body.

4. The tabbing apparatus of claim 2, wherein the first transfer member is disposed to face an edge of the solar cell string.

5. The tabbing apparatus of claim 2, wherein the first direction is parallel to a length direction of the solar cell string, and
the support member and the first transfer member are arranged in a width direction of the solar cell string.

6. The tabbing apparatus of claim 5, wherein a width of the support member is smaller than a width of the solar cell string.

7. The tabbing apparatus of claim 5, wherein a sum of a width of the support member and a width of the first transfer member is larger than a width of the solar cell string.

8. The tabbing apparatus of claim 2, wherein the second transfer unit includes:
a second transfer member disposed to face the support member and configured to transfer the solar cell string in the first direction;
a third transfer member disposed to face the first transfer member at an initial position and installed to be reciprocally movable in a direction intersecting the first direction; and
a second driving member configured to adjust a movement direction of the third transfer member in conjunction with movement of the first transfer member.

9. The tabbing apparatus of claim 8, wherein a distance between the first transfer member and the third transfer member is smaller than a movement distance of the first transfer member in the first direction.

10. The tabbing apparatus of claim 8, wherein the second driving member moves the third transfer member from the initial position in a direction intersecting the first direction as the first transfer member is moved in the first direction.

11. The tabbing apparatus of any one of claims 1 to 10, wherein the solar cell string includes a first surface and a second surface which are opposite to each other,
the first heating unit includes a first heating member disposed to face the first surface and configured to heat the first surface, and
the second heating unit includes a second heating member disposed to face the second surface and configured to heat the second surface.

12. The tabbing apparatus of claim 11, wherein the second surface is disposed to face the first transfer unit and the second transfer unit.

13. The tabbing apparatus of claim 12, wherein the first heating member is spaced apart from the first transfer unit, and the second heating member is disposed inside the second transfer unit.

14. The tabbing apparatus of claim 11, wherein the first heating unit further includes a preheating member spaced apart from the first heating member and configured to heat the second surface.

15. The tabbing apparatus of claim 14, wherein the preheating member includes:
a first preheating member disposed to face the first heating member; and
a second preheating member spaced apart from the first preheating member in the first direction.
